# EUROPEAN PATENT SPECIFICATION

(11) **EP 3 846 284 B1**
(45) Date of publication and mention of the grant of the patent: **09.04.2025**
(21) Application number: 20217366.2
(22) Date of filing: 28.12.2020
(51) Int. Cl.: H01P 5/08, H01R 24/40, H03D 9/06

(54) **DEVICE FOR MIXING OR MULTIPLYING FREQUENCY**
VORRICHTUNG ZUM MISCHEN ODER MULTIPLIZIEREN VON FREQUENZEN
DISPOSITIF DE MÉLANGE OU DE MULTIPLICATION DE FRÉQUENCE

(30) Priority: 31.12.2019 CN 201911425351
(43) Date of publication of application: 07.07.2021
(73) Proprietor: Tsinghua University, Haidian District, Beijing 100084 (CN); Nuctech Company Limited, TongFang Building Shuangqinglu Road Haidian District Beijing 100084 (CN)
(72) Inventor: ZHAO, Ziran, Beijing, 100084 (CN); CHEN, Zhiqiang, Beijing, 100084 (CN); LI, Yuanjing, Beijing, 100084 (CN); HU, Haifan, Beijing, 100084 (CN); MA, Xuming, Beijing, 100084 (CN); HUANG, Shiwei, Beijing, 100084 (CN)
(74) Representative: Gunzelmann, Rainer

(56) References cited:
- CN-U- 209 133 661
- US-A- 4 276 655
- US-A- 4 641 369
- US-A1- 2019 088 388
- US-A1- 2019 341 666
- MEHDI I ET AL: "600 GHZ PLANAR-SCHOTTKY-DIODE SUBHARMONIC WAVEGUIDE MIXERS", 1996 IEEE MTT-S INTERNATIONAL MICROWAVE SYMPOSIUM DIGEST. SAN FRANCISCO, JUNE 17 - 21, 1996; [IEEE MTT-S INTERNATIONAL MICROWAVE SYMPOSIUM DIGEST], NEW YORK, IEEE, UI, 17 June 1996 (1996-06-17), pages 377 - 380, XP000704915, ISBN: 978-0-7803-3247-8
- MARSH S ET AL: "Design of low-cost 183 GHz subharmonic mixers for commercial applications", 20070215, vol. 1, no. 1, 15 February 2007 (2007-02-15), pages 1 - 6, XP006028046
- JEFFREY L HESLER ET AL: "Fixed-Tuned Submillimeter Wavelength Waveguide Mixers Using Planar Schottky-Barrier Diodes", IEEE TRANSACTIONS ON MICROWAVE THEORY AND TECHNIQUES, IEEE, USA, vol. 45, no. 5, 1 May 1997 (1997-05-01), XP011036807, ISSN: 0018-9480

## Description

### TECHNICAL FIELD

The present disclosure relates to a field of communication technology, and in particular to a device for mixing or multiplying frequency.

### BACKGROUND

In recent years, terahertz wave technology, as an important research field, has attracted more and more attention at home and abroad. No matter which aspect and frequency band the terahertz wave is applied to, the reception of the terahertz wave is necessary. For the most commonly used receiver based on superheterodyne system, a mixer for frequency down conversion is a key component. In a solid-state terahertz radar and communications system, because a low-noise amplifier is difficult to implement, the mixer becomes the first stage of the receiving end, so the performance of the mixer is directly related to the performance of the entire receiver system. At the same time, since it is difficult to achieve a high-performance local oscillator in the same frequency band, sub-harmonic mixing technology is an effective way to solve this problem.

With increased requirements of system performance, requirements of receiver indexes are also increasing. To improve integration or imaging resolution, multi-channel integration of the receiver is a key issue. Because the current terahertz mixers mainly use metal cavity materials such as copper or aluminum, which can achieve a good channel spacing, multi-channel at present is still spliced by independent single channels. However, due to limitations of machining requirements of the metal cavity, it is difficult to reduce the multi-channel spacing to improve the overall integration.

US4276655A concerns a cross-bar signal mixer suitable for low-cost high-yield mass production. The mixer configuration consists of a balanced planar taper section supported upon a dielectric substrate placed across the carrier and local oscillator wave guides perpendicular to the direction of electromagnetic energy propagation. Beam lead mixer diodes are connected across the feed-point of the taper section. The local oscillator energy is injected in transverse electric mode relation at the junction of the two mixer diodes, thereby effectively decoupling the local oscillator from the carrier signal input. The intermediate frequency energy is abstracted from the same point as the local oscillator energy is injected and is decoupled by a low-pass filter. The local oscillator and the intermediate frequency circuits are incorporated on the same planar substrate as the carrier signal circuit and are therefore not critical in design.

US4641369A concerns a radio-frequency mixer and a local oscillator integrated into a single housing, and including a Gunn-type oscillator coupled to the mixer by a section of microstrip transmission line and a section of suspended stripline. A broadside coupler in the suspended stripline provides dc and intermediate-frequency isolation for the mixer, and a block of dielectric material on the microstrip provides improved temperature compensation for the diode oscillator. The entire compact assembly has good conversion loss performance over a relatively wide frequency band, and is relatively insensitive to temperature changes.

CN209133661U concerns a terahertz mixer and an electronic device including the same. According to an embodiment, the terahertz mixer comprises a cavity used for respectively forming a radio frequency input waveguide and a local oscillator input waveguide and accommodating a suspended microstrip line, and steps are formed on the inner side surface of the cavity; and the suspended microstrip line is formedthrough a semiconductor growth process and is bridged on at least one part of the step, and the suspended microstrip line respectively extends into the cavities where the radio frequency input waveguide and the local oscillator input waveguide are located so as to respectively form microstrip line antennas for receiving a radio frequency input signal and a local oscillator input signal.

US2019088388A1 concerns a transmission line substrate including a stacked body that includes insulating base materials, first and second signal lines, and first and second ground conductors. The second signal line is provided on a layer different from the layer of the first signal line and extends in parallel with the first signal line. The first ground conductor is provided on the same layer as the layer of the second signal line and overlapped with the first signal line when viewed in the Z-axis direction. The second ground conductor is provided on the same layer as the layer of the first signal line and overlapped with the second signal line when viewed in the Z-axis direction. A first transmission line includes the first signal line, the first ground conductor, and an insulating base material, and a second transmission line includes the second signal line, the second ground conductor, and the insulating base material.

### SUMMARY

The present disclosure provides a device of mixing or multiplying frequency as defined in claim 1 and a device of mixing or multiplying frequency as defined in claim 8.

### BRIEF DESCRIPTION OF THE DRAWINGS

FIG. 1 shows a schematic diagram of a terahertz mixer including a single frequency conversion unit.
FIG. 2 shows a schematic diagram of a terahertz mixer including a plurality of frequency conversion units.
FIG. 3 shows a schematic diagram of a terahertz mixer including a single frequency conversion unit.
FIG. 4 shows a schematic diagram of a terahertz mixer including a plurality of frequency conversion units.
FIG. 5 shows a schematic diagram of a glass insulator
FIG. 6 shows a schematic diagram of a terahertz mixer including a single frequency conversion unit.
FIG. 7 shows a schematic diagram of a terahertz mixer including a plurality of frequency conversion units.
FIG. 8 shows a schematic diagram of a coaxial metal column structure.
FIG. 9 shows a schematic diagram of a terahertz mixer including a single frequency conversion unit.
FIG. 10 shows another schematic diagram of the terahertz mixer including a single frequency conversion unit shown in FIG. 9.
FIG. 11 shows a schematic diagram of a terahertz mixer including a plurality of frequency conversion units.
FIG. 12 shows a schematic diagram of a terahertz mixer including a single frequency conversion unit.
FIG. 13 shows another schematic diagram of the terahertz mixer including a single frequency conversion unit shown in FIG. 12.
FIG. 14 shows a schematic diagram of a terahertz mixer including a plurality of frequency conversion units.
FIG. 15 shows a schematic diagram of a terahertz mixer including a single frequency conversion unit according to an exemplary embodiment of the present disclosure.
FIG. 16 shows a schematic diagram of a terahertz mixer including a plurality of frequency conversion units according to another exemplary embodiment of the present disclosure.
FIG. 17 shows a schematic diagram of a terahertz mixer including a single frequency conversion unit according to an exemplary embodiment of the present disclosure.
FIG. 18 shows a schematic diagram of a terahertz mixer including a plurality of frequency conversion units according to another exemplary embodiment of the present disclosure.
FIG. 19 shows a schematic diagram of a terahertz mixer including a plurality of frequency conversion units according to yet another exemplary embodiment of the present disclosure.
FIG. 20 shows a schematic diagram of a terahertz mixer including a plurality of frequency conversion units according to yet another exemplary embodiment of the present disclosure.
FIG. 21 shows a schematic diagram of a terahertz mixer including a single frequency conversion unit according to another exemplary embodiment of the present disclosure.
FIG. 22 shows a schematic diagram of a terahertz mixer including a plurality of frequency conversion units according to yet another exemplary embodiment of the present disclosure.
FIG. 23 shows a schematic diagram of a distribution of a plurality of frequency conversion units of the terahertz mixer on the box body according to another exemplary embodiment of the present disclosure.
FIG. 24 shows a schematic diagram of a distribution of a plurality of frequency conversion units of the terahertz mixer on the cover according to another exemplary embodiment of the present disclosure.

### DETAILED DESCRIPTION OF EMBODIMENTS

The following detailed description, for the convenience of explanation, many specific details are set forth to provide a comprehensive understanding of the embodiments of the present disclosure. Obviously, however, one or more embodiments may also be implemented without these specific details. In other cases, well-known structures and devices are shown in diagrammatic form to simplify the drawings.

According to a general inventive concept of the present disclosure, there is provided a device of mixing or multiplying frequency, including: a metal housing including a box body and a cover buckled together to define a metal cavity; and at least one frequency conversion unit including a microstrip line located in the metal cavity; and a channel structure including a radio frequency signal input channel, a local oscillator signal input channel and a signal output channel, the radio frequency signal input channel, the local oscillator signal input channel and the signal output channel pass through the metal housing and are coupled to the microstrip line respectively, wherein at least two of a plane where the radio frequency signal input channel is located, a plane where the local oscillator signal input channel is located and a plane where the signal output channel is located are not coplanar.

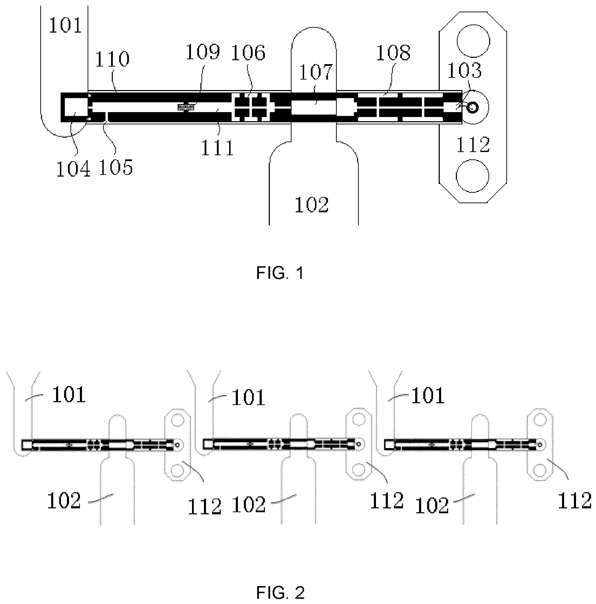

FIG. 1 shows a schematic diagram of a terahertz mixer including a single frequency conversion unit.

FIG. 2 shows a schematic diagram of a terahertz mixer including a plurality of frequency conversion units.

As shown in FIGS. 1 and 2, the frequency conversion unit of the terahertz mixer includes a microstrip line 107 and a channel structure. The microstrip line 107 is located in the metal cavity. The channel structure includes a radio frequency signal input channel 101, a local oscillator signal input channel 102 and a signal output channel, which pass through the metal housing and are coupled to the microstrip line 107 respectively. A part of the microstrip line 107 respectively extends to the metal cavity where the radio frequency signal input channel 101 and the local oscillator signal input channel 102 are located, so as to form an antenna 104 for receiving radio frequency input signals and local oscillator input signals. Other composition parts and dimension parameters of the mixer may refer to the prior art, or other documents or patents.

The specific content of this solution will be described below in combination with more specific examples. It should be understood that the dimensions and proportions in the figures are only for illustration and have nothing to do with the actual structure.

As shown in FIGS. 1 and 2, the radio frequency signal input channel 101 and the local oscillator signal input channel 102 of the mixer are respectively formed in the box body (or cover) defining the metal cavity and are parallel to the plane where the microstrip line 107 is located, and the signal output channel (which is an intermediate frequency signal output channel in this embodiment) is perpendicular to the plane where the microstrip line 107 is located and is led out from the cover or box body through an SMA connector 112. The terahertz mixer changes, by using the SMA connector 112, a direction along which the intermediate frequency signal of the mixer is led out, from the direction parallel to the plane where the microstrip line 107 is located to the direction perpendicular to the plane where the microstrip line 107 is located, thereby avoiding the problem of poor integration due to the presence of the radio frequency signal input channel, the local oscillator signal input channel and the signal output channel in the same plane. Moreover, it reduces the complexity and processing cost of multi-channel integration while ensuring the basic high-frequency characteristics of the mixer, which improves the flexibility of the mixer integration mode, and provides favorable conditions for further system integration.

In the embodiments shown in FIGS. 1 and 2, the SMA connector 112 is a wall-through structure and has a metal pin pointing outwards perpendicular to the principle plane. One end of the SMA connector 112 is level with the microstrip line 107 and connected to the intermediate frequency signal output port 103 of the microstrip line 107 through gold wire bonding, so as to realize a vertical led-out of the intermediate frequency signal. Those skilled in the art should understand that the SMA connector 112 may also adopt other connectors, such as a 2.92 mm connector.

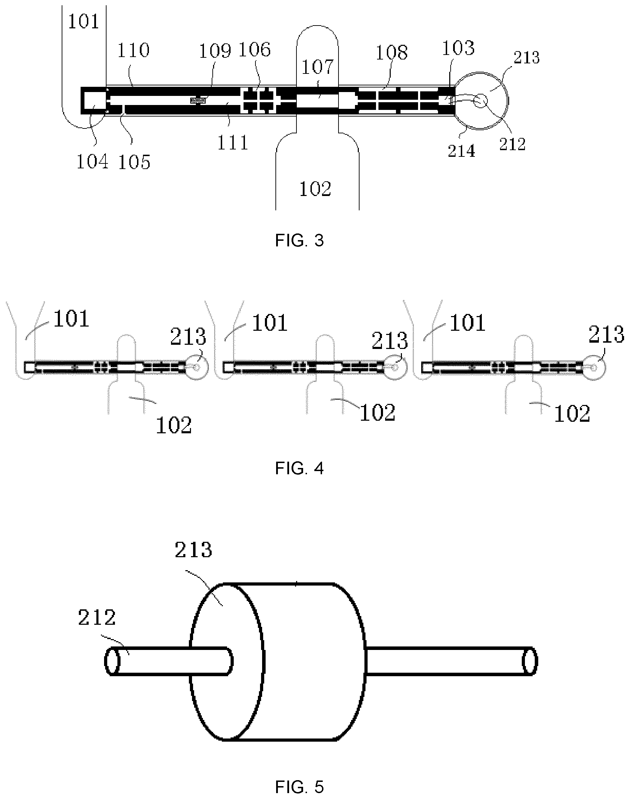

FIG. 3 shows a schematic diagram of a terahertz mixer including a single frequency conversion unit. FIG. 4 shows a schematic diagram of a terahertz mixer including a plurality of frequency conversion units. FIG. 5 shows a schematic diagram of a glass insulator.

**In** FIGS. 3 and 4, the signal output channel is led out vertically through a glass insulator. Specifically, as shown in FIG. 5, the glass insulator includes a metal pin 212 and a first columnar portion 213 sheathed on the middle of the metal pin 212. The metal pin 212 points outwards perpendicular to the principle plane, with a first end being level with the microstrip line 107 and connected to the intermediate frequency signal output port 103 of the microstrip line 107 through gold wire bonding. The first columnar part 213 is made of insulating glass medium. A metal layer 214 is provided on an outer surface of the first columnar part 213. The first columnar part 213 is connected to the cover or box body defining the metal housing, for example, located in a hole formed in the cover or box body.

A second end of the metal pin 212 of the glass insulator, which is opposite to the first end, is connected with an SMA connector so as to be connected to an external component.

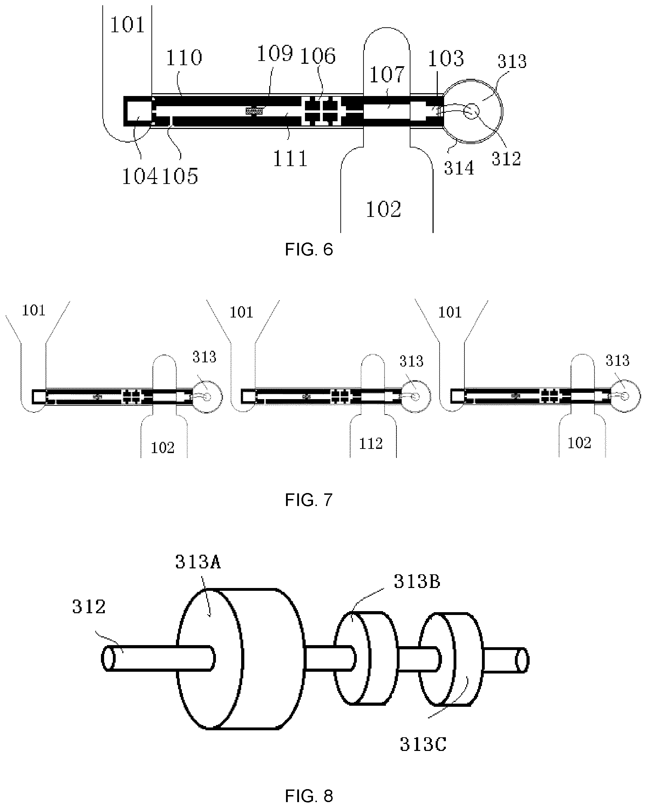

FIG. 6 shows a schematic diagram of a terahertz mixer including a single frequency conversion unit. FIG. 7 shows a schematic diagram of a terahertz mixer including a plurality of frequency conversion units. FIG. 8 shows a schematic diagram of a coaxial metal column structure.

In FIGS. 6 and 7, the signal output channel is led out vertically through the coaxial metal column. Specifically, as shown in FIG. 8, the coaxial metal column includes a metal pin 312 and a plurality of second columnar parts 313A, 313B, 313C, which are spaced apart from each other and sleeved on the metal pin 312 along the axial direction of the metal pin 312. One of the second columnar parts 313A, 313B, 313C (preferably the one far away from the intermediate frequency signal output port 103) is connected to the metal housing. Each of second columnar parts 313A, 313B, 313C has a metal layer 314 provided on its external surface The metal pin 312 points outwards perpendicular to the principle plane, with a first end being level with the microstrip line 107 and connected to the intermediate frequency signal output port 103 of the microstrip line through gold wire bonding.

In FIG. 8, one of adjacent two of the second columnar parts 313A, 313B, 313C has a diameter difference from the other of the adjacent two of the second columnar parts 313A, 313B, 313C. The coaxial metal column adopts second columnar parts with different diameters to form effective filter characteristics, so that radio frequency signals and local oscillator signals may be filtered to ensure the output of intermediate frequency signals. Since the coaxial metal column integrates a low-pass filter, the overall length of the quartz microstrip line is shortened, thereby improving the integration of the multi-channel mixer.

A second end of the metal pin 312 of the coaxial metal column, which is opposite to the first end, is connected with an SMA connector so as to be connected to an external component.

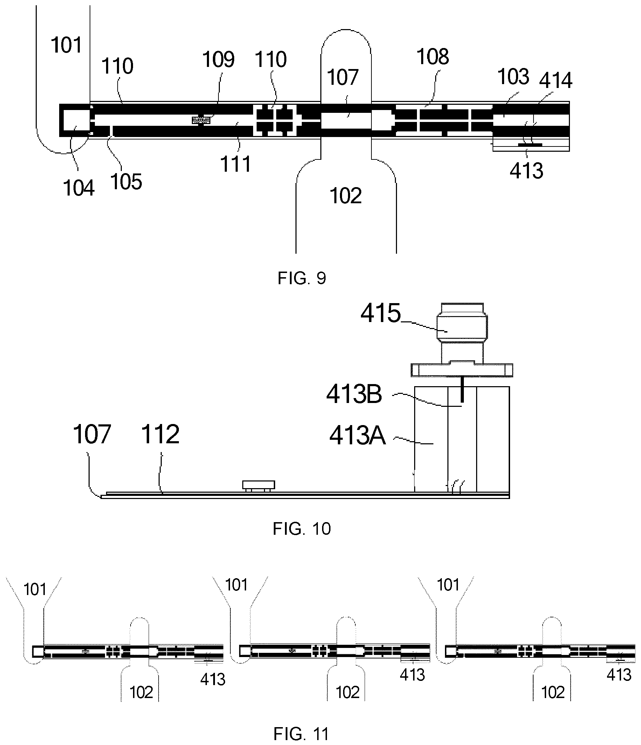

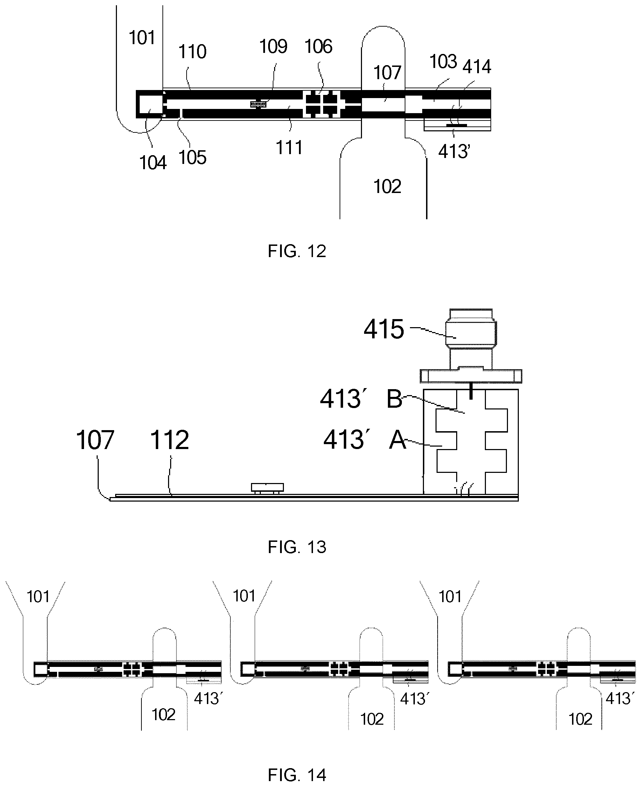

FIG. 9 shows a schematic diagram of a terahertz mixer including a single frequency conversion unit. FIG. 10 shows another schematic diagram of the terahertz mixer including a single frequency conversion unit shown in FIG. 9. FIG. 11 shows a schematic diagram of a terahertz mixer including a plurality of frequency conversion units FIG. 12 shows a schematic diagram of a terahertz mixer including a single frequency conversion unit.

FIG. 13 shows another schematic diagram of the terahertz mixer including a single frequency conversion unit shown in FIG. 12. FIG. 14 shows a schematic diagram of a terahertz mixer including a plurality of frequency conversion units.

In FIG. 9 and FIG. 10, the terahertz mixer changes the intermediate signal led-out direction of the mixer, through a Rogers board 413, from the direction parallel to the plane where the microstrip line 107 is located to the direction perpendicular to the plane where the microstrip line 107 is located, thereby avoiding the problem of poor integration due to the presence of the radio frequency signal input channel, the local oscillator signal input channel and the signal output channel in the same plane.

In FIG. 9 and FIG. 10, the Rogers board 413 includes a Rogers dielectric material 413A and metal strip lines 413B located on opposite sides of the Rogers dielectric material 413A. A first end of the Rogers board 413 is level with the microstrip line 107 and connected to an intermediate frequency led-out structure 414 of the microstrip line 107 through gold wire bonding, thereby achieving vertical led-out of the intermediate frequency signal.

In FIG. 9 and FIG. 10, a second end of the Rogers board 413 opposite to the first end is connected with an SMA connector 415 so as to be connected with an external component. Those skilled in the art should understand that the SMA connector 415 may also adopt other connectors, such as a 2.92 mm connector.

In FIG. 12 and FIG. 13, a Rogers board 413' having a high and low impedance stripline structure is employed to simultaneously serve as an intermediate frequency low pass filter, thereby filtering radio frequency local oscillator signals and allowing transmission of intermediate frequency signals.

**The** characteristic impedance of the Rogers board 413' may include but is not limited to 50 ohms, so as to match the SMA connector 415 (or other connectors such as a 2.92 mm connector).

As shown in FIG. 1 to FIG. 4, FIG. 6, FIG. 7, FIG. 9, FIG. 11, FIG. 12 and FIG. 14, the radio frequency signal input channel 101 and the local oscillator signal input channel 102 of the frequency conversion unit are both led in perpendicularly to the length direction of the microstrip line 107 and are couple to the microstrip line. Those skilled in the art should understand that in some other embodiments of the present disclosure, the radio frequency signal input channel 101 and the local oscillator signal input channel 102 of the frequency conversion unit may also be led in along other directions. For example, the radio frequency signal input channel 101 and the local oscillator signal input channel 102 of the frequency conversion unit are both led in in parallel to the length direction of the microstrip line 107 and are coupled to the microstrip line through a 90 ° turn.

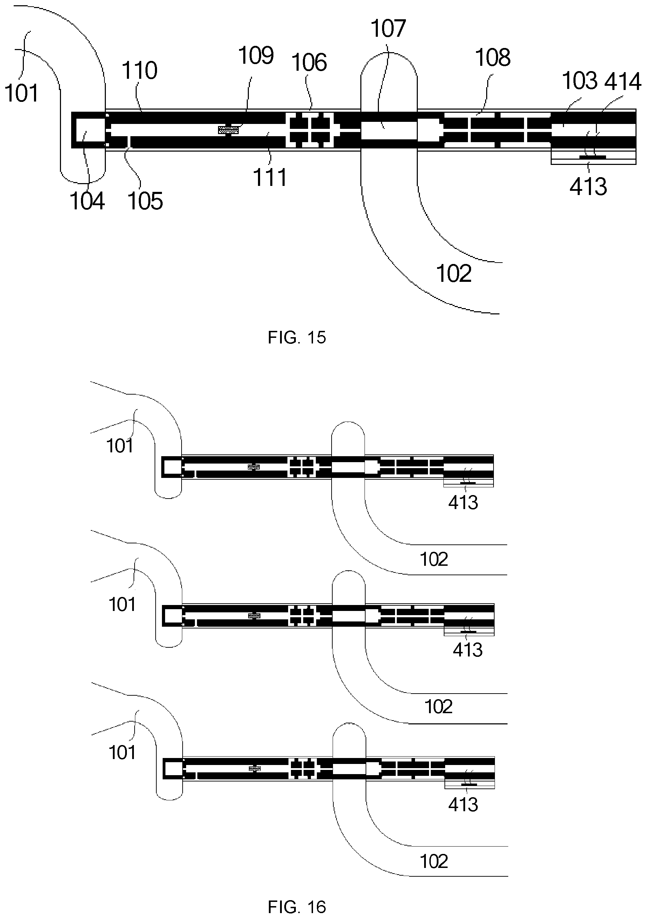

FIG. 15 shows a schematic diagram of a terahertz mixer including a single frequency conversion unit according to an exemplary embodiment of the present disclosure. FIG. 16 shows a schematic diagram of a terahertz mixer including a plurality of frequency conversion units according to yet another exemplary embodiment of the present disclosure.

In an exemplary embodiment of the present disclosure, as shown in FIG. 15 and FIG. 16, the radio frequency signal input channel 101 and the local oscillator signal input channel 102 of the frequency conversion unit are both led in in parallel to the length direction of the microstrip line 107 and are couple to the microstrip line through a 90 ° turn. Those skilled in the art should understand that in some other embodiments of the present disclosure, the radio frequency signal input channel 101 and the local oscillator signal input channel 102 of the frequency conversion unit may also be led in along other directions, and the angle of the turn may also be other angles, such as 45 °, 60 ° or the like.

In an exemplary embodiment of the present disclosure, as shown in FIG. 1 to FIG. 4, FIG. 6, FIG. 7, FIG. 9, FIG. 11, FIG. 14 and FIG. 16, the radio frequency signal input channel 101 and the local oscillator signal input channel 102 of the frequency conversion unit are led in along opposite directions, so as to avoid interference of the radio frequency signal input channel 101, the local oscillator signal input channel 102 and their associated components in spatial position, and also shorten the overall length of the microstrip line 107, thereby improving the integration of the mixer. However, it should be noted that in some other embodiments of the present disclosure, the radio frequency signal input channel 101 and the local oscillator signal input channel 102 of the frequency conversion unit may also be led in along the same direction. In addition, in some other embodiments of the present disclosure, the led-in direction of the radio frequency signal input channel 101 may be not in parallel with the led-in direction of the local oscillator signal input channel 102 of the frequency conversion unit.

In an exemplary embodiment of the present disclosure, as shown in FIG. 1 to FIG. 4, FIG. 6, FIG. 7, FIG. 9 and FIG. 11, each of the radio frequency signal input channel 101 and the local oscillator signal input channel 102 of the frequency conversion unit is led in perpendicularly to the length direction of the microstrip line 107 and is couple to the microstrip line. In this case, when the device includes a plurality of frequency conversion units, the plurality of frequency conversion units are arranged in a row along the length direction of the microstrip line 107.However, those skilled in the art should understand that in some other embodiments of the present disclosure, other arrangements may also be adopted, and the specific arrangements may be adjusted according to requirements.

In an exemplary embodiment, as shown in FIG. 15 and FIG. 16, the radio frequency signal input channel 101 and the local oscillator signal input channel 102 of the frequency conversion unit are both led in in parallel to the length direction of the microstrip line 107 and are coupled to the microstrip line 107 through a 90 ° turn. In this case, if the device includes a plurality of frequency conversion units, the plurality of frequency conversion units are arranged in a row along the direction perpendicular to the length direction of the microstrip line 107. However, those skilled in the art should understand that in some other embodiments of the present disclosure, other arrangements may also be adopted, and the specific arrangements may be adjusted according to requirements.

In practice, the design of the vertical led-out part of the intermediate frequency signal needs to be optimized to reduce return loss and optimize output characteristics of the intermediate frequency signal.

In an exemplary embodiment, as shown in FIG. 1 to FIG. 4, FIG. 6, FIG. 7, FIG. 9, FIG. 11, and FIG. 14 to FIG. 16, the radio frequency signal input channels 101 in each row of frequency conversion units are parallel to each other with their ports being aligned, and the local oscillator signal input channels 102 are parallel to each other with their ports being aligned, so as to ensure consistence between the signal reception of the multi-channel receiver and the input local oscillator signal.

It should be noted that although in the above-mentioned embodiments, the intermediate frequency signal led-out direction of the mixer is changed, through the SMA connector or the glass insulator or the coaxial metal column or the Rogers board, from the direction parallel to the plane where the microstrip line 107 is located to the direction perpendicular to the plane where the microstrip line 107 is located, those skilled in the art should understand that in some other embodiments of the present disclosure, the intermediate frequency signal led-out direction may also be at an angle with respect to the plane where the microstrip line 107 is located, and the angle is not equal to zero.

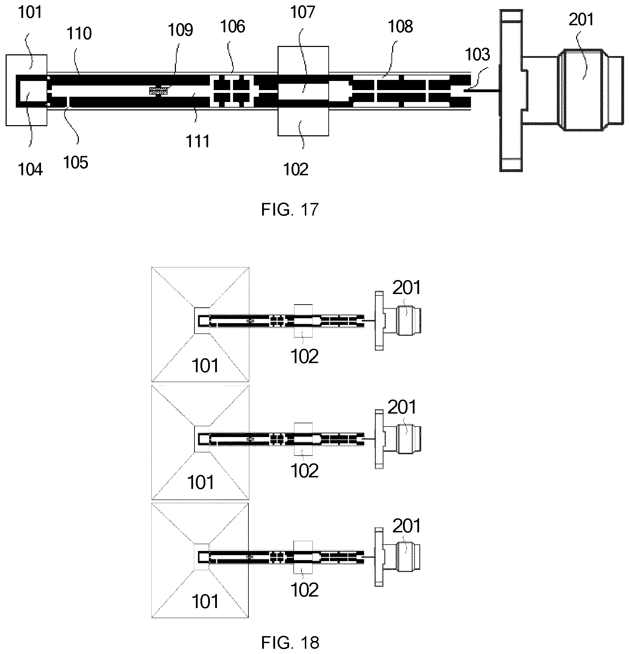

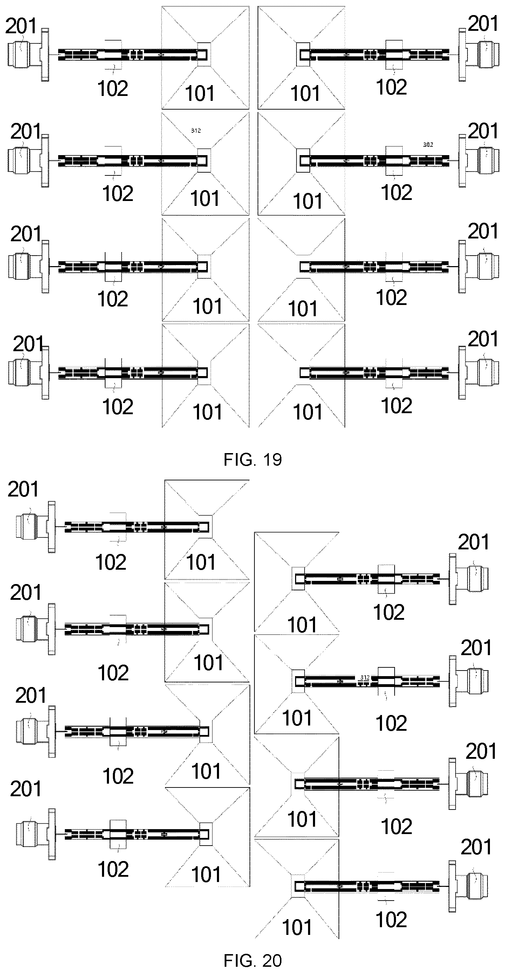

FIG. 17 shows a schematic diagram of a terahertz mixer including a single frequency conversion unit according to an exemplary embodiment of the present disclosure. FIG. 18 shows a schematic diagram of a terahertz mixer including a plurality of frequency conversion units according to another exemplary embodiment of the present disclosure. FIG. 19 shows a schematic diagram of a terahertz mixer including a plurality of frequency conversion units according to yet another exemplary embodiment of the present disclosure. FIG. 20 shows a schematic diagram of a terahertz mixer including a plurality of frequency conversion units according to yet another exemplary embodiment of the present disclosure.

As shown in FIG. 17 to FIG. 20, the radio frequency signal input channel 101 and the local oscillator signal input channel 102 of the mixer according to the present disclosure are both led in perpendicularly to the plane where the microstrip line 107 is located. Here, the radio frequency signal input channel 101 transmits inwards perpendicular to the principle plane, the local oscillator signal input channel 102 transmits outwards perpendicular to the principle plane,, and the signal output channel (which is the intermediate frequency signal output channel in this embodiment) is led out in parallel to the plane where the microstrip line 107 is located. The terahertz mixer changes the direction where the radio frequency signal input channel 101 and the local oscillator signal input channel 102 are led out, from the direction parallel to the plane where the microstrip line 107 is located to the direction perpendicular to the plane where the microstrip line 107 is located, thereby avoiding the problem of poor integration due to the presence of the radio frequency signal input channel, the local oscillator signal input channel and the signal output channel in the same plane. Moreover, it reduces the complexity and processing cost of multi-channel integration while ensuring the basic high-frequency characteristics of the mixer, which improves the flexibility of the mixer integration mode and provides favorable conditions for further system integration.

In the exemplary embodiments shown in FIG. 17 to FIG. 20, the radio frequency signal input channel 101 and the local oscillator signal input channel 102 are both perpendicular to the plane where the microstrip line 107 is located, and may be machined by means of wire cutting in the cover or box body defining the metal cavity. The SMA connector 201 (or other connectors such as a 2.92 mm connector) is a wall-through structure. Its metal pin protrudes in a direction parallel to the microstrip line 107, and may be welded to the intermediate frequency output port 103 of the microstrip line 107 through conductive glue, or an intermediate frequency transition welding may be realized by using the Rogers board.

In an exemplary embodiment of the present disclosure, as shown in FIG. 17 to FIG. 20, the radio frequency signal input channel 101 and the local oscillator signal input channel 102 of the frequency conversion unit are led in along opposite directions, so as to avoid interference of the radio frequency signal input channel 101, the local oscillator signal input channel 102 and their associated components in spatial position, and also shorten the overall length of the microstrip line 107, thereby improving the integration of the mixer. However, it should be noted that in some other embodiments of the present disclosure, the radio frequency signal input channel 101 and the local oscillator signal input channel 102 of the frequency conversion unit may also be led in along the same direction. In addition, in some other embodiments of the present disclosure, the radio frequency signal input channel 101 of the frequency conversion unit may be led in along a direction not in parallel with the direction along which the local oscillator signal input channel 102 of the frequency conversion unit is led in.

In an exemplary embodiment, as shown in FIG. 18 to FIG. 20, if the device includes a plurality of frequency conversion units, the plurality of frequency conversion units are arranged in a row (as shown in FIG. 18) or two rows (as shown in FIG. 19 and FIG. 20) along a direction perpendicular to the length direction of the microstrip line 107.

In an exemplary embodiment, as shown in FIG. 19, the plurality of frequency conversion units are arranged in two rows along the direction perpendicular to the length direction of the microstrip line 107. The frequency conversion units in the two rows are level with each other in the length direction of the microstrip line 107.

In an exemplary embodiment, as shown in FIG. 20, the plurality of frequency conversion units are arranged in two rows along the direction perpendicular to the length direction of the microstrip line 107. The frequency conversion units in the two rows are staggered one by one in the length direction of the microstrip line 107.

In an exemplary embodiment, as shown in FIG. 17 to FIG. 20, the radio frequency signal input channel 101 has an H-surface probe transition structure, and the local oscillator signal input channel 102 has an H-surface probe transition structure. In practice, the design of the H-surface probe transition structure needs to be optimized to reduce the return loss and optimize the output characteristics of the intermediate frequency signal.

In an exemplary embodiment, as shown in FIG. 18 to FIG. 20, the radio frequency signal input channels 101 in each row of frequency conversion units are parallel to each other with their ports being aligned, and the local oscillator signal input channels 102 are parallel to each other with their ports being aligned, so as to ensure the consistence between the signal reception of the multi-channel receiver and the input local oscillator signal.

In the exemplary embodiments shown in FIG. 17 to FIG. 20, since the radio frequency signal input channel 101 and the local oscillator signal input channel 102 are led in perpendicularly to the plane where the microstrip line 107 is located, the spacing between channels is shortened and the integration is improved. In practice, the size may not be further shortened due to a large size of the connector, then a custom connector of the intermediate frequency output may be employed to achieve the purpose of small size.

The operating process of the mixer shown in FIG. 17 to FIG. 20 includes the following. The terahertz signal to be received passes through the radio frequency signal input channel 101. In the waveguide-transition-microstrip line structure of the H-surface probe, the terahertz signal is transmitted to the antenna 104 of the microstrip line 107. The local oscillator signal enters from the local oscillator signal input channel 102, passes through a microstrip transition structure 107 of a duplexer and a local oscillator low-pass filter 106, and is then mixed with the radio frequency signal in a gallium arsenide Schottky diode 109. The radio frequency signal is mixed with second harmonic of the local oscillator. The differential intermediate frequency signal passes through an intermediate frequency filter 108 to the intermediate frequency signal output port 103, and is then transmitted to a load through the SMA connector or other connectors such as a 2.92 mm connector. In order to avoid DC offset caused by the inconsistency of the pair of Schottky diodes 109, a ground line 105 connected to the metal cavity is led out from the microstrip line 107. The ground line 105 may be applied to the nearest metal cavity by using conductive silver glue, or may be welded to the nearest metal cavity by gold wire bonding.

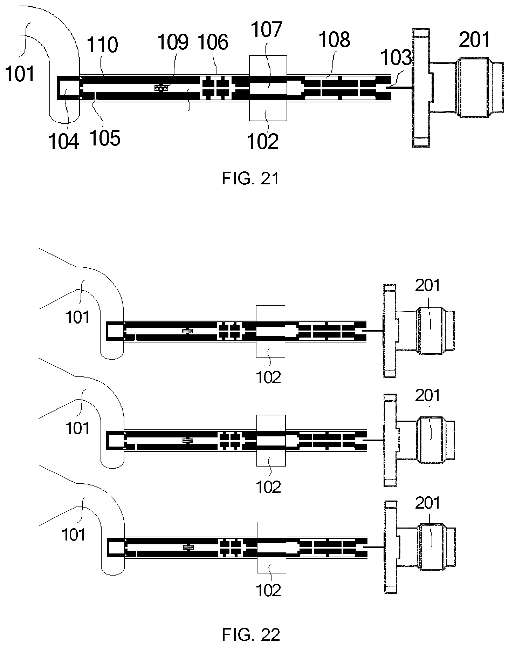

FIG. 21 shows a schematic diagram of a terahertz mixer including a single frequency conversion unit according to another exemplary embodiment of the present disclosure. FIG. 22 shows a schematic diagram of a terahertz mixer including a plurality of frequency conversion units according to yet another exemplary embodiment of the present disclosure.

In an exemplary embodiment of the present disclosure, as shown in FIG. 21 and FIG. 22, the radio frequency signal input channel 101 of the frequency conversion unit is led in in parallel to the length direction of the microstrip line and is coupled to the microstrip line through a 90 ° turn. The local oscillator signal input channel 102 of the frequency conversion unit is led in perpendicularly to the plane where the microstrip line 107 is located. The signal output channel is led in in parallel to the plane where the microstrip line is located. This also avoids the problem of poor integration due to the presence of the radio frequency signal input channel, the local oscillator signal input channel and the signal output channel in the same plane. Moreover, it reduces the complexity and processing cost of multi-channel integration while ensuring the basic high-frequency characteristics of the mixer, which improves the flexibility of the mixer integration mode and provides favorable conditions for further system integration.

In the exemplary embodiment shown in FIG. 21 and FIG. 22, the radio frequency signal input channel 101 is in parallel to the length direction of the microstrip line 107, the local oscillator signal input channel 102 is perpendicular to the plane where the microstrip line 107 is located, and both the radio frequency signal input channel 101 and the local oscillator signal input channel 102 may be machined by means of wire cutting in the cover or box body defining the metal cavity. The SMA connector 201 (or other connectors such as a 2.92mm connector) is a wall-through structure. Its metal pin extends in a direction parallel to the microstrip line 107, and may be welded to the intermediate frequency output port 103 of the microstrip line 107 through conductive glue, or an intermediate frequency transition welding may be realized by using the Rogers board.

Those skilled in the art should understand that in some other embodiments of the present disclosure, the local oscillator signal input channel 101 of the frequency conversion unit may also be led in in parallel to the length direction of the microstrip line 107 and be coupled to the microstrip line through a 90 ° turn, and the radio frequency signal input channel 101 of the frequency conversion unit may be led in perpendicularly to the plane where the microstrip line is located, and the signal output channel may be led out in parallel to the plane where the microstrip line 107 is located.

In an exemplary embodiment of the present disclosure, as shown in FIG. 21 and FIG. 22, the radio frequency signal input channel 101 of the frequency conversion unit is led in in parallel to the length direction of the microstrip line 107 and is coupled to the microstrip line 107 through a 90 ° turn, so as to reduce the overall arrangement size of a single frequency conversion unit. Those skilled in the art should understand that in some other embodiments of the present disclosure, the radio frequency signal input channel 101 of the frequency conversion unit may also be led in along other directions, and the angle of the turn may also be other angles, such as 45 °, 60 ° or the like.

In an exemplary embodiment, as shown in FIG. 21, if the device includes a plurality of frequency conversion units, the plurality of frequency conversion units are arranged in a row along the direction perpendicular to the length direction of the microstrip line 107.

In an exemplary embodiment, the radio frequency signal input channel 101 has an E-surface probe transition structure, and the local oscillator signal input channel 102 has an H-surface probe transition structure. In some other embodiments of the present disclosure, the radio frequency signal input channel 101 has an H-surface probe transition structure, and the local oscillator signal input channel 102 has an E-surface probe transition structure. In practice, the design of the probe transition structure needs to be optimized to reduce the return loss and optimize the output characteristics of the intermediate frequency signal.

The operating process of the above-mentioned mixer as shown in FIG. 21 and FIG. 22 includes the following. The terahertz signal that to be received passes through the radio frequency signal input channel 101. In the waveguide-transition-microstrip line structure of the E-surface probe, the terahertz signal is transmitted to the antenna 104 of the microstrip line 107. The local oscillator signal enters from the local oscillator signal input channel 102, passes through a microstrip transition structure 107 of a duplexer and a local oscillator low-pass filter 106, and then mixes with the radio frequency signal in a gallium arsenide Schottky diode 109. The radio frequency signal is mixed with second harmonic of the local oscillator. The differential intermediate frequency signal passes through an intermediate frequency filter 108 to the intermediate frequency signal output port 103, and then is transmitted to a load. In order to avoid DC offset caused by the inconsistency of the pair of Schottky diodes 109, a ground line 105 connected to the metal cavity is led out from the microstrip line 107. The ground line 105 may be applied to the nearest metal cavity by using conductive silver glue, or may be welded to the nearest metal cavity by gold wire bonding.

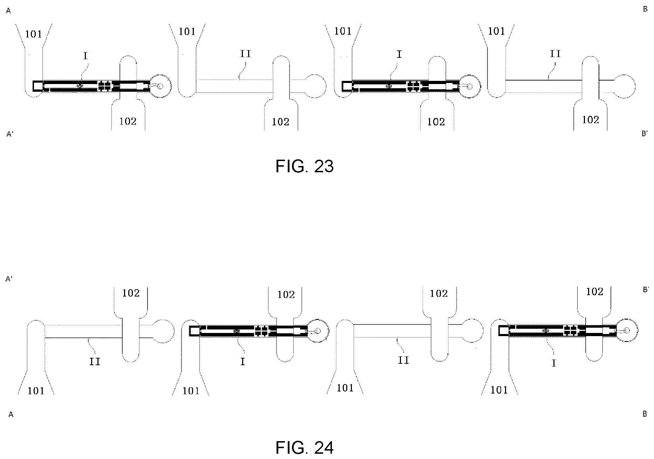

FIG. 23 shows a schematic diagram of a distribution of a plurality of frequency conversion units of the terahertz mixer on the box body according to another exemplary embodiment of the present disclosure. FIG. 24 shows a schematic diagram of a distribution of a plurality of frequency conversion units of the terahertz mixer on the cover according to another exemplary embodiment of the present disclosure.

In an exemplary embodiment, as shown in FIGS. 23 and 24, in case that the device includes a plurality of frequency conversion units, the plurality of frequency conversion units are divided into two groups, which are respectively arranged in the box body (see FIG. 23) and the cover (see FIG. 24) and arranged in mirror symmetry. Specifically, a microstrip line assembly position I of the frequency conversion unit in the cover corresponds to an air cavity position II on the microstrip line of the frequency conversion unit in the box body, and the air cavity position II on the microstrip line of the frequency conversion unit in the cover corresponds to the microstrip line assembly position I of the frequency conversion unit in the box body. In this way, the upper and lower adjacent channels have opposite intermediate frequency signal extraction directions, so as to be led out from the box body and the cover respectively, thereby reserving a large space for the SMA connector or glass insulator or coaxial metal column etc.. If the SMA connector or glass insulator or coaxial metal column etc. has the maximum outer diameter a, then it is only needed to ensure that the spacing between channels is not less than a/2. If the spacing between channels needs to be further reduced, a custom small-size connector on the intermediate frequency output port may be employed.

In an exemplary embodiment, as shown in FIG. 23 and FIG. 24, the signal output channels 103 of each row of frequency conversion units are in parallel to each other, and two adjacent signal output channels are led out in opposite directions, so as to further reserve a large space for the SMA connector or glass insulator or coaxial metal column.

In an exemplary embodiment, as shown in FIG. 23 and FIG. 24, A-A' to B'-B are marked at the corresponding positions of the box body and the cover to avoid incorrect buckling.

It should be noted that if the device includes a plurality of frequency conversion units, the plurality of frequency conversion units may be one group all arranged on the box body or all arranged on the cover.

In an exemplary embodiment, the local oscillator signal input channels 102 of the plurality of frequency conversion units may be collected to a port through a (one to four, or one to eight) power divider, and then input signals through the local oscillator source, so as to realize the simultaneous operation of the mixer.

It should be noted that the microstrip line 107 may be a quartz substrate-based microstrip line structure, or a sapphire-based microstrip line structure, or a common microstrip line structure, or a suspended microstrip line structure, or a monolithic integrated microstrip circuit of gallium arsenide (GaAs), or a monolithic integrated microstrip circuit of indium phosphide (InP). In addition, the material of the metal housing includes but is not limited to alloy metals such as aluminum or brass, and semiconductor materials based on silicon, or gallium arsenide, indium phosphide, and the like. The metal cavity defined by the metal housing may be a shielded cavity structure with a metal inner wall processed by a Micro-Electro-Mechanical System (MEMS) technology, or a shielded cavity structure with a metal inner wall processed by a micro-coaxial technology.

In addition, in an exemplary embodiment of the present disclosure, the antenna 104 may be integrated and processed together with the radio frequency signal input channel 101. The size of the antenna 104 may be optimized according to the channel spacing to ensure the system's requirements for receiver parameters..

In addition, those skilled in the art should understand that the harmonic type of the mixer is not limited, and it may be a single-ended, single-balanced, double-balanced, triple-balanced, or I/Q passive mixer. The plurality of local oscillator signal input channels of the mixer may be collected to a port through a (one to four, or one to eight) power divider, and then input signals through the local oscillator source, so as to realize the simultaneous operation of the mixer.

With the terahertz mixer, at least two of a plane where the radio frequency signal input channel is located, a plane where the local oscillator signal input channel is located and a plane where the signal output channel is located are not coplanar, thereby avoiding the problem of poor integration due to the presence of the radio frequency signal input channel, the local oscillator signal input channel and the signal output channel in the same plane. Moreover, it reduces the complexity and processing cost of multi-channel integration while ensuring the basic high-frequency characteristics of the mixer, which improves the flexibility of the mixer integration mode, and provides favorable conditions for further system integration. In addition, although the foregoing embodiments are all described by taking the mixer as an example, those skilled in the art should understand that in some other embodiments of the present disclosure, the device is also applicable to a frequency multiplier.

Those skilled in the art may understand that the embodiments described above are exemplary, and those skilled in the art may make improvements. The structures described in the various embodiments may be combined freely without conflicts in structure or principle.

## Claims

1. A device for mixing or multiplying frequency, comprising:
a metal housing, comprising a box body and a cover buckled together to define a metal cavity;
at least one frequency conversion unit, comprising:
a microstrip line (107) located in the metal cavity; and
a channel structure comprising a radio frequency signal input channel (101), a local oscillator signal input channel (102) and a signal output channel, the radio frequency signal input channel (101), the local oscillator signal input channel (102) and the signal output channel pass through the metal housing and are coupled to the microstrip line (107) respectively, wherein at least two of a plane where the radio frequency signal input channel (101) is located, a plane where the local oscillator signal input channel (102) is located and a plane where the signal output channel is located are not coplanar,
wherein the signal output channel is led out perpendicularly to a plane where the microstrip line (107) is located;
wherein each of the radio frequency signal input channel (101) and the local oscillator signal input channel (102) is located in a plane in parallel to the plane where the microstrip line (107) is located, **characterized in that**: each of the radio frequency signal input channel (101) and the local oscillator signal input channel (102) extends in a direction in parallel to a length direction of the microstrip line (107); and
wherein each of the radio frequency signal input channel (101) and the local oscillator signal input channel (102) is coupled to the microstrip line (107) through a turn.

2. The device according to claim 1, wherein the device comprises a plurality of frequency conversion units, the plurality of frequency conversion units are divided into one group or two groups, and the frequency conversion units of each group are arranged in a row along the length direction of the microstrip line (107).

3. The device according to claim 1, wherein the plurality of frequency conversion units are divided into two groups, the two groups of frequency conversion units are respectively disposed in the box body and the cover, and are arranged in mirror symmetry,
wherein the radio frequency signal input channels (101) of each row of the frequency conversion units are in parallel to each other and ports of the radio frequency signal input channels (101) of each row of the frequency conversion units are aligned with each other, and the local oscillator signal input channels (102) of each row of the frequency conversion units are in parallel to each other and ports the local oscillator signal input channels (102) of each row of the frequency conversion units are aligned with each other,
wherein the signal output channels of each row of the frequency conversion units are in parallel to each other, and two adjacent signal output channels of each row of the frequency conversion units are led out along opposite directions.

4. The device according to claim 1, wherein the radio frequency signal input channel (101) and the local oscillator signal input channel (102) are led in along opposite directions.

5. The device according to claim 4, wherein the device comprises a plurality of frequency conversion units, the plurality of frequency conversion units are divided into one group or two groups, and the frequency conversion units of each group are arranged in a row along a direction perpendicular to the length direction of the microstrip line (107).

6. The device according to claim 5, wherein the plurality of frequency conversion units are divided into two groups, the two groups of frequency conversion units are respectively disposed in the box body and the cover, and are arranged in mirror symmetry,
wherein the radio frequency signal input channels (101) of each row of the frequency conversion units are in parallel to each other and ports of the radio frequency signal input channels (101) of each row of the frequency conversion units are aligned with each other, and the local oscillator signal input channels (102) of each row of the frequency conversion units are in parallel to each other and ports of the local oscillator signal input channels (102) of each row of the frequency conversion units are aligned with each other.

7. The device according to claim 1, wherein the device comprises a plurality of channel structures, and the local oscillator signal input channels (102) of the plurality of channel structures are gathered to one port through a power divider.

8. A device for mixing or multiplying frequency, comprising:
a metal housing, comprising a box body and a cover buckled together to define a metal cavity;
at least one frequency conversion unit, comprising:
a microstrip line (107) located in the metal cavity; and
a channel structure comprising a radio frequency signal input channel (101), a local oscillator signal input channel (102) and a signal output channel, the radio frequency signal input channel (101), the local oscillator signal input channel (102) and the signal output channel pass through the metal housing and are coupled to the microstrip line (107) respectively, wherein at least two of a plane where the radio frequency signal input channel (101) is located, a plane where the local oscillator signal input channel (102) is located and a plane where the signal output channel is located are not coplanar,
wherein the signal output channel is led out in parallel to a plane where the microstrip line (107) is located;
**characterized in that**:
one of the radio frequency signal input channel (101) and the local oscillator signal input channel (102) is led in in parallel to the plane where the microstrip line (107) is located, and is coupled to the microstrip line (107) through a turn, and the other of the radio frequency signal input channel (101) and the local oscillator signal input channel (102) is led in perpendicularly to the plane where the microstrip line (107) is located.

9. The device according to claim 8, wherein a direction along which the radio frequency signal input channel (101) is led in is the same as a direction along which the signal output channel is led out.

10. The device according to claim 9, wherein the device comprises a plurality of frequency conversion units, the plurality of frequency conversion units are divided into one group or two groups, and the frequency conversion units of each group are arranged in a row along a direction perpendicular to the length direction of the microstrip line (107).

11. The device according to claim 10, wherein the plurality of frequency conversion units are divided into two groups, the two groups of frequency conversion units are respectively disposed in the box body and the cover, and are arranged in mirror symmetry.

## Patentansprüche

1. Eine Vorrichtung zum Mischen oder Vervielfachen von Frequenz, umfassend:
ein Metallgehäuse, umfassend einen Kasten und einen Deckel, die zusammengeklipst sind, um einen Metallhohlraum zu bilden;
mindestens eine Frequenzumwandlungseinheit, umfassend:
eine Mikrostreifenleitung (107), die in dem Metallhohlraum angeordnet ist; und
eine Kanalstruktur, die einen Hochfrequenzsignaleingangskanal (101), einen Lokaloszillatorsignaleingangskanal (102) und einen Signalausgangskanal umfasst, wobei der Hochfrequenzsignaleingangskanal (101), der Lokaloszillatorsignaleingangskanal (102) und der Signalausgangskanal jeweils durch das Metallgehäuse führen und mit der Mikrostreifenleitung (107) gekoppelt sind, wobei mindestens zwei unter einer Ebene, in der sich der Hochfrequenzsignaleingangskanal (101) befindet, einer Ebene, in der sich der Lokaloszillatorsignaleingangskanal (102) befindet, und einer Ebene, in der sich der Signalausgangskanal befindet, nicht koplanar sind,
wobei der Signalausgangskanal senkrecht zu einer Ebene, in der sich die Mikrostreifenleitung (107) befindet, herausgeführt ist;
wobei sich sowohl der Hochfrequenzsignaleingangskanal (101) als auch der Lokaloszillatorsignaleingangskanal (102) in einer Ebene befindet, die parallel zu der Ebene ist, in der sich die Mikrostreifenleitung (107) befindet,
**dadurch gekennzeichnet, dass** sich sowohl der Hochfrequenzsignaleingangskanal (101) als auch der Lokaloszillatorsignaleingangskanal (102) in einer Richtung erstreckt, die parallel zu einer Längsrichtung der Mikrostreifenleitung (107) ist; und
wobei jeder der Hochfrequenzsignaleingangskanäle (101) und der Lokaloszillatorsignaleingangskanäle (102) durch eine Biegung mit der Mikrostreifenleitung (107) gekoppelt ist.

2. Die Vorrichtung nach Anspruch 1, wobei die Vorrichtung eine Vielzahl von Frequenzumwandlungseinheiten umfasst, die Vielzahl von Frequenzumwandlungseinheiten in eine Gruppe oder zwei Gruppen unterteilt ist und die Frequenzumwandlungseinheiten jeder Gruppe in einer Reihe entlang der Längsrichtung der Mikrostreifenleitung (107) angeordnet sind.

3. Die Vorrichtung nach Anspruch 1, wobei die Vielzahl von Frequenzumwandlungseinheiten in zwei Gruppen unterteilt ist, die beiden Gruppen von Frequenzumwandlungseinheiten jeweils in dem Kasten und dem Deckel angeordnet sind und in Spiegelsymmetrie angeordnet sind,
wobei die Hochfrequenzsignaleingangskanäle (101) jeder Reihe von Frequenzumwandlungseinheiten zueinander parallel sind und Anschlüsse der Hochfrequenzsignaleingangskanäle (101) jeder Reihe von Frequenzumwandlungseinheiten zueinander ausgerichtet sind, und die Lokaloszillatorsignaleingangskanäle (102) jeder Reihe von Frequenzumwandlungseinheiten zueinander parallel sind und Anschlüsse der Lokaloszillatorsignaleingangskanäle (102) jeder Reihe von Frequenzumwandlungseinheiten zueinander ausgerichtet sind,
wobei die Signalausgangskanäle jeder Reihe von Frequenzumwandlungseinheiten zueinander parallel sind und zwei benachbarte Signalausgangskanäle jeder Reihe von Frequenzumwandlungseinheiten in entgegengesetzte Richtungen herausgeführt sind.

4. Die Vorrichtung nach Anspruch 1, wobei der Hochfrequenzsignaleingangskanal (101) und der Lokaloszillatorsignaleingangskanal (102) in entgegengesetzten Richtungen eingeführt werden.

5. Die Vorrichtung nach Anspruch 4, wobei die Vorrichtung eine Vielzahl von Frequenzumwandlungseinheiten umfasst, die Vielzahl von Frequenzumwandlungseinheiten in eine Gruppe oder zwei Gruppen unterteilt ist und die Frequenzumwandlungseinheiten jeder Gruppe in einer Reihe entlang einer Richtung angeordnet sind, die senkrecht zur Längsrichtung der Mikrostreifenleitung (107) verläuft.

6. Die Vorrichtung nach Anspruch 5, wobei die Vielzahl von Frequenzumwandlungseinheiten in zwei Gruppen unterteilt ist, die beiden Gruppen von Frequenzumwandlungseinheiten jeweils in dem Kasten und dem Deckel angeordnet sind und in Spiegelsymmetrie angeordnet sind,
wobei die Hochfrequenzsignaleingangskanäle (101) jeder Reihe von Frequenzumwandlungseinheiten zueinander parallel sind und Anschlüsse der Hochfrequenzsignaleingangskanäle (101) jeder Reihe von Frequenzumwandlungseinheiten zueinander ausgerichtet sind, und die Lokaloszillatorsignaleingangskanäle (102) jeder Reihe von Frequenzumwandlungseinheiten zueinander parallel sind und Anschlüsse der Lokaloszillatorsignaleingangskanäle (102) jeder Reihe von Frequenzumwandlungseinheiten zueinander ausgerichtet sind.

7. Die Vorrichtung nach Anspruch 1, wobei die Vorrichtung eine Vielzahl von Kanalstrukturen umfasst und die Lokaloszillatorsignaleingangskanäle (102) der Vielzahl von Kanalstrukturen mittels eines Leistungsaufteilers zu einem Anschluss zusammengeführt sind.

8. Eine Vorrichtung zum Mischen oder Vervielfachen von Frequenz, umfassend:
ein Metallgehäuse, umfassend einen Kasten und einen Deckel, die zusammengeklipst sind, um einen Metallhohlraum zu bilden;
mindestens eine Frequenzumwandlungseinheit, umfassend:
eine Mikrostreifenleitung (107), die in dem Metallhohlraum angeordnet ist; und
eine Kanalstruktur, die einen Hochfrequenzsignaleingangskanal (101), einen Lokaloszillatorsignaleingangskanal (102) und einen Signalausgangskanal umfasst, wobei der Hochfrequenzsignaleingangskanal (101), der Lokaloszillatorsignaleingangskanal (102) und der Signalausgangskanal jeweils durch das Metallgehäuse führen und mit der Mikrostreifenleitung (107) gekoppelt sind, wobei mindestens zwei unter einer Ebene, in der sich der Hochfrequenzsignaleingangskanal (101) befindet, einer Ebene, in der sich der Lokaloszillatorsignaleingangskanal (102) befindet, und einer Ebene, in der sich der Signalausgangskanal befindet, nicht koplanar sind,
wobei der Signalausgangskanal parallel zu einer Ebene, in der sich die Mikrostreifenleitung (107) befindet, herausgeführt ist;
**dadurch gekennzeichnet, dass**:
einer der Hochfrequenzsignaleingangskanal (101) und der Lokaloszillatorsignaleingangskanal (102) parallel zu der Ebene, in der sich die Mikrostreifenleitung (107) befindet, eingeführt ist und durch eine Biegung mit der Mikrostreifenleitung (107) gekoppelt ist, und der andere der Hochfrequenzsignaleingangskanal (101) und der Lokaloszillatorsignaleingangskanal (102) senkrecht zu der Ebene, in der sich die Mikrostreifenleitung (107) befindet, eingeführt ist.

9. Die Vorrichtung nach Anspruch 8, wobei eine Richtung, in der der Hochfrequenzsignaleingangskanal (101) eingeführt wird, dieselbe ist wie eine Richtung, in der der Signalausgangskanal herausgeführt wird.

10. Die Vorrichtung nach Anspruch 9, wobei die Vorrichtung eine Vielzahl von Frequenzumwandlungseinheiten umfasst, die Vielzahl von Frequenzumwandlungseinheiten in eine Gruppe oder zwei Gruppen unterteilt ist und die Frequenzumwandlungseinheiten jeder Gruppe in einer Reihe entlang einer Richtung angeordnet sind, die senkrecht zur Längsrichtung der Mikrostreifenleitung (107) verläuft.

11. Die Vorrichtung nach Anspruch 10, wobei die Vielzahl von Frequenzumwandlungseinheiten in zwei Gruppen unterteilt ist, die beiden Gruppen von Frequenzumwandlungseinheiten jeweils in dem Kasten und dem Deckel angeordnet sind und in Spiegelsymmetrie angeordnet sind.

## Revendications

1. Dispositif de mélange ou de multiplication de fréquences, comprenant:
un boîtier métallique, comprenant un corps de boîte et un couvercle assemblés pour former une cavité métallique;
au moins une unité de conversion de fréquence, comprenant:
une ligne microruban (107) se trouvant dans la cavité métallique; et
une structure de canal comprenant un canal radiofréquence d'entrée de signal (101), un canal d'entrée de signal d'oscillateur local (102) et un canal de sortie de signal, le canal radiofréquence d'entrée de signal (101), le canal d'entrée de signal d'oscillateur local (102) et le canal de sortie de signal traversent le boîtier métallique et sont respectivement couplés à la ligne microruban (107), dans lequel au moins deux parmi un plan dans lequel se trouve le canal radiofréquence d'entrée de signal (101), un plan dans lequel se trouve le canal d'entrée de signal d'oscillateur local (102) et un plan dans lequel se trouve le canal de sortie de signal, ne sont pas coplanaires,
dans lequel, le canal de sortie de signal s'étend perpendiculairement à un plan dans lequel se trouve la ligne microruban (107);
dans lequel le canal radiofréquence d'entrée de signal (101) et le canal d'entrée de signal d'oscillateur local (102) sont tous deux situés dans un plan parallèle au plan dans lequel se trouve la ligne microruban (107),
**caractérisé en ce que**: le canal radiofréquence d'entrée de signal (101) et le canal d'entrée de signal d'oscillateur local (102) s'étendent chacun dans un sens parallèle au sens de la longueur de la ligne microruban (107); et
dans lequel le canal radiofréquence d'entrée de signal (101) et le canal d'entrée de signal d'oscillateur local (102) sont chacun couplés à la ligne microruban (107) en faisant une boucle autour de cette dernière.

2. Dispositif selon la revendication 1, dans lequel le dispositif comprend une pluralité d'unités de conversion de fréquence, la pluralité d'unités de conversion de fréquence sont divisées en un groupe ou deux groupes, et les unités de conversion de fréquence de chaque groupe sont disposées en rangée dans le sens de la longueur de la ligne microruban (107).

3. Dispositif selon la revendication 1, dans lequel la pluralité des unités de conversion de fréquence est divisée en deux groupes, les deux groupes d'unités de conversion de fréquence sont respectivement disposés dans le corps de boîte et dans le couvercle, et sont disposés en symétrie miroir,
dans lequel les canaux d'entrée de signal de fréquence radio (101) de chaque rangée des unités de conversion de fréquence sont parallèles les uns aux autres et les ports des canaux d'entrée de signal de fréquence radio (101) de chaque rangée des unités de conversion de fréquence sont alignés les uns aux autres, et les canaux d'entrée de signal d'oscillateur local (102) de chaque rangée des unités de conversion de fréquence sont parallèles les uns aux autres et les ports des canaux d'entrée du signal de l'oscillateur local (102) de chaque rangée des unités de conversion de fréquence sont alignés les uns aux autres,
dans lequel les canaux de sortie de signal de chaque rangée des unités de conversion de fréquence sont parallèles les uns aux autres, et deux canaux de sortie de signal adjacents de chaque rangée des unités de conversion de fréquence s'étendent dans des sens opposés.

4. Dispositif selon la revendication 1, dans lequel le canal radiofréquence d'entrée de signal (101) et le canal d'entrée de signal d'oscillateur local (102) s'étendent dans des sens opposés.

5. Dispositif selon la revendication 4, dans lequel le dispositif comprend une pluralité d'unités de conversion de fréquence, la pluralité d'unités de conversion de fréquence sont divisées en un groupe ou deux groupes, et les unités de conversion de fréquence de chaque groupe sont disposées en rangée dans un sens perpendiculaire au sens de la longueur de la ligne microruban (107).

6. Dispositif selon la revendication 5, dans lequel la pluralité des unités de conversion de fréquence est divisée en deux groupes, les deux groupes d'unités de conversion de fréquence sont respectivement disposés dans le corps de boîte et dans le couvercle, et sont disposés en symétrie miroir,
dans lequel les canaux d'entrée de signal de fréquence radio (101) de chaque rangée des unités de conversion de fréquence sont parallèles les uns aux autres et les ports des canaux d'entrée de signal de fréquence radio (101) de chaque rangée des unités de conversion de fréquence sont alignés les uns aux autres, et les canaux d'entrée de signal d'oscillateur local (102) de chaque rangée des unités de conversion de fréquence sont parallèles les uns aux autres et les ports des canaux d'entrée du signal de l'oscillateur local (102) de chaque rangée des unités de conversion de fréquence sont alignés les uns aux autres.

7. Dispositif selon la revendication 1, dans lequel le dispositif comprend une pluralité de structures de canaux, et les canaux d'entrée de signal d'oscillateur local (102) de la pluralité de structures de canaux sont rassemblés sur un port par l'intermédiaire d'un diviseur de puissance.

8. Dispositif de mélange ou de multiplication de fréquences, comprenant:
un boîtier métallique, comprenant un corps de boîte et un couvercle assemblés pour former une cavité métallique;
au moins une unité de conversion de fréquence, comprenant:
une ligne microruban (107) située dans la cavité métallique; et
une structure de canal comprenant un canal radiofréquence d'entrée de signal (101), un canal d'entrée de signal d'oscillateur local (102) et un canal de sortie de signal, le canal radiofréquence d'entrée de signal de (101), le canal d'entrée de signal d'oscillateur local (102) et le canal de sortie de signal traversent le boîtier métallique et sont respectivement couplés à la ligne microruban (107), dans lequel au moins deux parmi un plan où est situé le canal radiofréquence d'entrée de signal (101), un plan où est situé le canal d'entrée de signal d'oscillateur local (102) et un plan où est situé le canal de sortie de signal, ne sont pas coplanaires,
dans lequel le canal de sortie de signal s'étend parallèlement à un plan où se trouve la ligne microruban (107);
**caractérisé en ce que**:
un parmi le canal radiofréquence d'entrée de signal (101) et le canal d'entrée de signal d'oscillateur local (102) s'étend parallèlement au plan dans lequel se trouve la ligne microruban (107) et sont couplés à la ligne microruban (107) en faisant une boucle autour cette dernière, et l'autre parmi le canal radiofréquence d'entrée de signal de (101) et le canal d'entrée de signal d'oscillateur local (102) s'étend perpendiculairement au plan dans lequel se trouve la ligne microruban (107).

9. Dispositif selon la revendication 8, dans lequel le sens dans lequel s'étend le canal radiofréquence d'entrée de signal (101) est le même que le sens dans lequel s'étend le canal de sortie de signal.

10. Dispositif selon la revendication 9, dans lequel le dispositif comprend une pluralité d'unités de conversion de fréquence, la pluralité d'unités de conversion de fréquence sont divisées en un groupe ou deux groupes, et les unités de conversion de fréquence de chaque groupe sont disposées en rangée dans un sens perpendiculaire au sens de la longueur de la ligne microruban (107).

11. Dispositif selon la revendication 10, dans lequel la pluralité d'unités de conversion de fréquence est divisée en deux groupes, les deux groupes d'unités de conversion de fréquence sont respectivement disposés dans le corps de la boîte et dans le couvercle, et sont disposés en symétrie miroir.
